# EUROPÄISCHE PATENTSCHRIFT

(11) **EP 0 661 524 B1**
(45) Veröffentlichungstag und Bekanntmachung des Hinweises auf die Patenterteilung: **24.02.1999**
(21) Anmeldenummer: 94810697.6
(22) Anmeldetag: 05.12.1994
(51) Int. Cl.: G01D 5/34, G01R 15/24

(54) **Faseroptischer Transmissionssensor mit Modulator**
Fibre-optic transmission sensor with a modulator
Capteur à transmission à fibres optiques avec un modulateur

(30) Priorität: 29.12.1993 DE 4344856
(43) Veröffentlichungstag der Anmeldung: 05.07.1995
(73) Patentinhaber: ABB RESEARCH LTD., 8050 Zürich (CH)
(72) Erfinder: Meier, Markus, Dr., CH-5000 Aarau (CH)
(74) Vertreter: Weibel, Beat

(56) Entgegenhaltungen:
- EP-A- 0 448 342
- IEEE TRANSACTIONS ON POWER DELIVERY, Bd. 7, Nr. 2, April 1992, NEW YORK US, Seiten 848-852, XP000275216 MCDOUGALL ET AL.: "DEVELOPMENT OF A FIBER OPTIC CURRENT SENSOR..."
- OPTICS LETTERS, Bd. 18, Nr. 2, 15.Januar 1993, WASHINGTON US, Seiten 158-160, XP000331276 CLARKE: "TEMPERATURE-STABLE SPUN ELLIPTICAL-CORE OPTICAL-FIBER CURRENT TRANSDUCER"

## Beschreibung

### TECHNISCHES GEBIET

Bei der Erfindung wird ausgegangen von einem faseroptischen Transmissionssensor mit Modulator nach dem Oberbegriff des Patentanspruchs 1.

### STAND DER TECHNIK

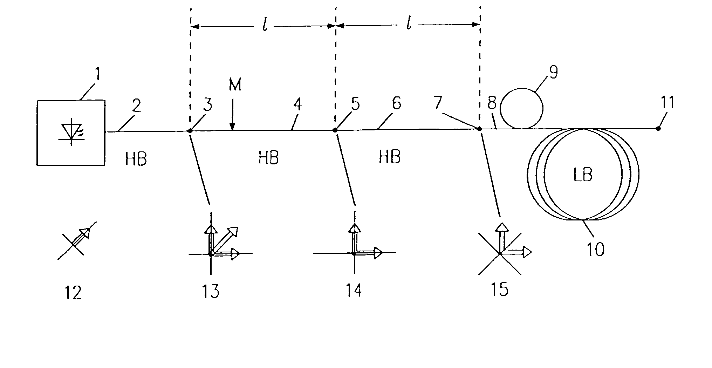

Mit dem Oberbegriff des Patentanspruchs 1 nimmt die Erfindung auf einen Stand der Technik Bezug, wie er durch Roland Stierlin, Faseroptische Sensoren, Bulletin SEV/VSE 82 (1991), S. 21 - 29, bekannt ist. Bei dem dort in Verbindung mit Bild 8 beschriebenen Sagnac-Sensortyp wird linear polarisiertes Laserlicht parallel in 2 HB-Lichtfasern (stark doppelbrechende Lichtfasern) zum Sensorkopf und von dort in zueinander entgegengesetzten Richtungen über 2 λ/4-Platten in die Sensorfaser geführt. Die beiden λ/4-Platten stehen unter 45° zur Richtung der linearen Polarisation in der jeweiligen HB-Faser, so daß von beiden Seiten rechtszirkular polarisiertes Licht in die Sensorfaser gelangt. Die Sensorfaser ist eine verdrillte LB-Glasfaser (niedrig doppelbrechende Glasfaser). Nach dem Durchgang durch die jeweils zweite. λ/4-Platte wird das Licht wieder in den linearen Polarisationszustand zurückverwandelt. Die Polarisationsrichtung des austretenden Lichtes ist dabei parallel zu derjenigen des eintretenden. Das Licht wird über die beiden HB-Glasfasern zurückgeführt und in einer Sende-Auswerteinheit in einem ersten Verzweiger vereinigt und über einen Eingangspolarisator in einem zweiten Verzweiger vom Eingangslichtpfad ausgekoppelt. Mit diesem Sagnac-Stromsensor wird der Phasenunterschied der beiden Lichtstrahlen durch Interferenzbildung gemessen. In einer HB-Glasfaser ist ein Phasenmodulator, z. B. durch Festkleben eines gewickelten Teiles der HB-Glasfaser auf einem piezoelektrischen Element, angebracht, durch den beide Lichtstrahlen phasenmoduliert werden. Durch den Laufzeitunterschied, der dadurch entsteht, daß der rechts und links umlaufende Lichtstrahl nicht zur gleichen Zeit den Modulator passieren, wird die Phase der beiden Lichtstrahlen nicht im gleichen Takt moduliert. Eine Analyse der perodischen Änderung des Interferenzsignals liefert einen Gleich- und einen Wechselstromanteil der Modulationsfrequenz, welche Anteile durch eine Verhältnisbildung ausgewertet werden, sowie höhere Harmonische. Die Länge der Sensorfaser ist mit der Stärke und der Frequenz der Phasenmodulation abgestimmt. Einer der 2 unabhängigen Lichtstrahlen wird als Referenz für den anderen verwendet.

Die Signalauswertung ist bei diesem Sensortyp relativ aufwendig.

### DARSTELLUNG DER ERFINDUNG

Die Erfindung, wie sie im Patentanspruch 1 definiert ist, löst die Aufgabe, einen faseroptischen Transmissionssensor mit Modulator der eingangs genannten Art derart weiterzuentwickeln, daß eine einfachere Signalauswertung möglich wird.

Ein Vorteil der Erfindung besteht in einem vergleichsweise einfachen Aufbau der Lichtübertragungsstrecke von einer Lichtquelle zum Glasfasersensor. Eine temperaturabhängige Drehung von verdrillten Faserspulen kann dabei kompensiert werden.

### KURZE BESCHREIBUNG DER ZEICHNUNG

Die Erfindung wird nachstehend anhand eines Ausführungsbeispiels erläutert. Die einzige Figur zeigt schematisch eine Lichtübertragung von einer Lichtquelle über HB-Lichtfasern in eine Sensorfaser.

### WEG ZUR AUSFÜHRUNG DER ERFINDUNG

Von einer monochromatischen Lichtquelle (1), vorzugsweise von einer Laserdiode, wird monochromatisches Licht über einen nicht dargestellten Monochromator in eine polarisationserhaltende, stark doppelbrechende sog. HB-Lichtfaser bzw. Zuleitungslichtfaser (2) mit zwei optischen Hauptachsen, d. h. mit einer ersten und dazu orthogonalen zweiten optischen Hauptachse, eingekoppelt. In der ersten optischen Hauptachse der Zuleitungsglasfaser (2) ist die Ausbreitungsgeschwindigkeit des Lichtes größer ist als in der zweiten optischen Hauptachse. Die Polarisationsrichtung des von der Lichtquelle (1) einzukoppelnden Lichtes ist parallel zu einer der beiden optischen Hauptachsen der Zuleitungslichtfaser (2).

In einer optischen Kopplungsstelle bzw. Spleißstelle (3) ist die Zuleitungslichtfaser (2) mit einer polarisationserhaltenden, stark doppelbrechenden HB-Lichtfaser bzw. erste Referenzlichtfaser (4) mit zwei optischen Hauptachsen, d. h. mit einer ersten und dazu orthogonalen zweiten optischen Hauptachse optisch verbunden, wobei die beiden optischen Hauptachsen der ersten Referenzlichtfaser (4) gegenüber den beiden Hauptachsen der Zuleitungslichtfaser (2) um 45° gedreht sind. In einer weiteren Spleißstelle (5) ist die erste Referenzlichtfaser (4) mit einer im Aufbau gleichen zweiten Referenzlichtfaser (6) verbunden, wobei jedoch die beiden optischen Hauptachsen der ersten Referenzlichtfaser (4) gegenüber den beiden Hauptachsen der zweiten Referenzlichtfaser (6) um 90° gedreht sind. Die erste Referenzlichtfaser (4) hat die gleiche Länge (1) wie die zweite Referenzlichtfaser (6).

In einer dritten Spleißstelle (7) ist die zweite Referenzlichtfaser (6) mit einer niedrigdoppelbrechenden sogenannten. LB-Lichtfaser bzw. Lichtfaser (8) optisch verbunden. Die Lichtfaser (8) bildet zunächst eine λ/4-Lichtleiterschleife (9) und danach in mehreren Schleifen einen optischen Sensor (10) bzw. Faraday-Sensor z. B. zur Detektion eines Stromes durch ein nicht dargestelltes Stromkabel im Innenraum der Sensorschleife (10). Ein Ausgang (11) der Lichtfaser (8) kann mit einem Polarimeter oder einem weiteren Modulator oder einer HB-Lichtfaser in optischer Verbindung stehen (nicht dargestellt).

Mit (12) ist eine Schwingungsebene des aus der Lichtquelle (1) austretenden Lichtes parallel zu einer Hauptachse der Zuleitungslichtfaser (2) bezeichnet. (13) bezeichnet eine Schwingungsebene des Lichtes am Ausgang der Spleißstelle (3). Dadurch, daß die beiden in der Spleißstelle (3) miteinander gekoppelten HB-Lichtfasern (2, 4) bezüglich der Richtung ihrer Hauptachsen um 45° gedreht sind, wird Licht gleicher Amplitude in beide polarisationserhaltende Hauptachsen eingekoppelt. Die Schwingungsebenen des Lichtes an den Spleißstellen (5) und (7) sind mit (14) bzw. (15) bezeichnet.

Nach einer Länge (1) in der ersten Referenzlichtfaser (4) kann sich das Licht in einem unbestimmten Zustand befinden, d. h. partiell oder nicht kohärent sein. Da die Rollen der beiden Hauptachsen in der Spleißstelle (5) getauscht werden, hat jede Polarisationskomponente vom Eingang der ersten Referenzlichtfaser (4) an der Spleißstelle (7) praktisch den gleichen optischen Weg durchlaufen, d. h., die beiden Polarisationskomponenten sind wieder kohärent. Die relative Phase ist nicht genau bekannt; sie hängt von Asymmetrien in den beiden ersten und zweiten Referenzlichtfasern (4, 6) ab, d. h. von Temperatur- und Fabrikationsschwankungen.

Mit einem Phasenmodulator (M) kann man die Phasenverschiebung beeinflussen, entweder statisch mit einem Gleichanteil oder dynamisch mit einer vorgebbaren Frequenz.

Beim Eintritt der beiden Polarisationskomponenten in die λ/4-Lichtleiterschleife (9) wird eine Komponente in eine rechtszirkularpoarisierte und die andere in eine linkszirkularpolarisierte umgewandelt. Durch die relative Phase zwischen den beiden Polarisationskomponenten der zweiten Referenzlichtfaser (6), die man mit dem Phasenmodulator (M) beeinflussen kann, wird die Lage der linearen Polarisation, d. h. die Summe von rechts- und linkszirkularpolarisierten Komponenten, am Eingang der Lichtfaser (8) bestimmt.

Der erfindungsgemäße faseroptische Transmissionssensor ist als Polarisationsstellelement am Eingang der LB-Lichtfaser (8) verwendbar. Die Steuerung erfolgt durch die Gleichstromkomponente des Phasenmodulators (M). Mit einer schwachen Frequenzmodulation läßt sich die Polarisationsrichtung besser bestimmen. Mit einer starken Frequenzmodulation wird eine Phasenmodulation einer Faraday-Modulation bewirkt.

Wird der faseroptische Transmissionssensor am Ausgang der zweiten Referenzlichtfaser (6) (mit umgekehrter Reihenfolge der Lichtkomponenten) eingesetzt, so kann man bestimmen, welche Polarisationsrichtung am Ausgang (11) der Lichtfaser (8) symmetrisch auf das nicht dargestellte Polarimeter gelangt.

Mit zwei Phasenmodulatoren (M) (nicht dargestellt) läßt sich die Transfermatrix der Spule der Sensorlichtfaser (10) bestimmen.

Es versteht sich, daß anstelle einer λ/4-Lichtleiterschleife (9) z. B. eine λ/4-Verzögerungsplatte verwendet werden kann. Anstelle der Sensorlichtfaser (10) könnte ein massivoptischer Sensor verwendet werden.

### BEZEICHNUNGSLISTE

- 1: Lichtquelle, Laserdiode
- 2: Zuleitungslichtfaser, HB-Lichtfaser
- 3, 5, 7: Speißstellen, optische Kopplungsstellen
- 4, 6: erste und zweite Referenzlichtfasern, HB-Lichtfasern
- 8: LB-Lichtfaser
- 9: λ/4-Verzögerungseinrichtung,
λ/4-Lichtfaserschleife
- 10: Sensorlichtfaser, optischer Sensor,
Sensorschleife
- 11: Ausgang von 8
- 12 - 15: Schwingungsebenen

- l: Länge von 4 und 6
- M: Phasenmodulator

## Patentansprüche

1. Faseroptischer Transmissionssensor
a) mit einer Lichtquelle (1),
b) die über eine polarisationserhaltende, stark doppelbrechende ersten Referenzlichtfaser (4) mit einer ersten und dazu orthogonalen zweiten optischen Hauptachse, wobei in der ersten optischen Hauptachse die Ausbreitungsgeschwindigkeit des Lichtes größer ist als in der zweiten optischen Hauptachse, und
c) über eine polarisationserhaltende, stark doppelbrechende zweite Referenzlichtfaser (6) mit einer ersten und dazu orthogonalen zweiten optischen Hauptachse, wobei in der ersten optischen Hauptachse die Ausbreitungsgeschwindigkeit des Lichtes größer ist als in der zweiten optischen Hauptachse, sowie
d) über eine λ/4-Verzögerungseinrichtung (9) mit einem optischen Sensor (10) in optischer Verbindung steht,
e) ferner mit mindestens einem Phasenmodulator (M), der mit einer der beiden ersten oder zweiten Referenzlichtfasern (4, 6) in Wirkverbundung steht,
dadurch gekennzeichnet,
f) daß die erste Referenzlichtfaser (4) die gleiche Länge (l) wie die zweite Referenzlichtfaser (6) aufweist und
g) mit dieser um 90° gedreht optisch verbunden ist, derart, daß die erste optische Hauptachse der ersten Referenzlichtfaser (4) mit der zweiten optischen Hauptachse der zweiten Referenzlichtfaser (6) verbunden ist und die zweite optische Hauptachse der ersten Referenzlichtfaser (4) mit der ersten optischen Hauptachse der zweiten Referenzlichtfaser (6).

2. Faseroptischer Transmissionssensor nach Anspruch 1, dadurch gekennzeichnet, daß die Lichtquelle (1) über eine polarisationserhaltende, stark doppelbrechende Zuleitungslichtfaser (2) mit einer ersten und dazu orthogonalen zweiten optischen Hauptachse, wobei in der ersten optischen Hauptachse die Ausbreitungsgeschwindigkeit des Lichtes größer ist als in der zweiten optischen Hauptachse, mit der ersten Referenzlichtfaser (4) bezüglich deren erster und zweiter optischen Hauptachsen um 45° gedreht optisch verbunden ist, derart, daß die erste und zweite optischen Hauptachsen der ersten Referenzlichtfaser (4) mit den ersten und zweiten optischen Hauptachsen der Zuleitungslichtfaser (2) einen Winkel von 45° bilden.

3. Faseroptischer Transmissionssensor nach Anspruch 1 oder 2, dadurch gekennzeichnet, daß die λ/4-verzögerungseinrichtung (9) eine λ/4-Schleife einer niedrigdoppelbrechenden Lichtfaser (8) ist.

4. Faseroptischer Transmissionssensor nach einem der vorhergehenden Ansprüche, dadurch gekennzeichnet, daß die λ/4-Verzögerungseinrichtung (9) mit der zweiten Referenzlichtfaser (6) optisch gekoppelt ist.

5. Faseroptischer Transmissionssensor nach einem der vorhergehenden Ansprüche, dadurch gekennzeichnet, daß die λ/4-Verzögerungseinrichtung (9) und der optische Sensor (10) aus einer einzigen, niedrigdoppelbrechenden optischen Faser bestehen.

## Claims

1. Fibre-optic transmission sensor
a) having a light source (1),
b) which, via a polarization-maintaining, highly birefringent first reference optical fibre (4) having a first optical principal axis and a second orthogonal thereto, the propagation velocity of the light in the first optical principal axis being greater than in the second optical principal axis, and
c) via a polarization-maintaining, highly birefringent second reference optical fibre (6) having a first optical principal axis and a second orthogonal thereto, the propagation velocity of the light in the first optical principal axis being greater than in the second optical principal axis, and
d) via a λ/4-delay device (9), is connected optically to an optical sensor (10),
e) in addition having at least one phase modulator (M), which is operatively connected to one of the two first or second reference optical fibres (4, 6),
characterized in that,
f) the first reference optical fibre (4) has the same length (1) as the second reference optical fibre (6) and
g) is connected optically to the latter, rotated by 90°, in such a way that the first optical principal axis of the first reference optical fibre (4) is connected to the second optical principal axis of the second reference optical fibre (6), and the second optical principal axis of the first reference optical fibre (4) to the first optical principal axis of the second reference optical fibre (6).

2. Fibre-optic transmission sensor according to Claim 1, characterised in that the light source (1) is connected optically via a polarization-maintaining, highly birefringent feed line optical fibre (2) having a first optical principal axis and a second orthogonal thereto, the propagation velocity of the light in the first optical principal axis being greater than in the second optical principal axis, to the first reference optical fibre (4), rotated by 45° with reference to the first and second optical principal axes of the latter, in such a way that the first and second optical principal axes of the first reference optical fibre (4) form an angle of 45° with the first and second optical principal axes of the feed line optical fibre (2).

3. Fibre-optic transmission sensor according to Claim 1 or 2, characterized in that the λ/4-delay device (9) is a λ/4-loop of a weakly birefringent optical fibre (8).

4. Fibre-optic transmission sensor according to one of the preceding claims, characterized in that the λ/4-delay device (9) is optically coupled to the second reference optical fibre (6).

5. Fibre-optic transmission sensor according to one of the preceding claims, characterized in that the λ/4-delay device (9) and the optical sensor (10) comprise a single, weakly birefringent optical fibre.

## Revendications

1. Capteur à transmission à fibres optiques
a) muni d'une source de lumière (1),
b) qui est en liaison optique ayant un premier axe optique principal et un deuxième axe optique principal orthogonal au premier par le biais d'une première fibre optique de référence (4) fortement biréfringente à polarisation constante, la vitesse de propagation de la lumière dans le premier axe optique principal étant supérieure à celle dans le deuxième axe optique principal, et
c) ayant un premier axe optique principal et un deuxième axe optique principal orthogonal au premier par le biais d'une deuxième fibre optique de référence (6) fortement biréfringente à polarisation constante, la vitesse de propagation de la lumière dans le premier axe optique principal étant supérieure à celle dans le deuxième axe optique principal, et
d) par le biais d'un dispositif de temporisation λ/4 (9),
e) muni en outre d'au moins un modulateur de phase (M) qui est en liaison active avec l'une des deux première ou deuxième fibres optiques de référence (4, 6),
caractérisé par le fait
f) que la première fibre optique de référence (4) a la même longueur (1) que la deuxième fibre optique de référence (6) et
g) qu'elle est reliée optiquement à celle-ci avec une rotation de 90° de manière à ce que le premier axe optique principal de la première fibre optique de référence (4) soit relié au deuxième axe optique principal de la deuxième fibre optique de référence (6) et le deuxième axe optique principal de la première fibre optique de référence (4) au premier axe optique principal de la deuxième fibre optique de référence (6).

2. Capteur à transmission à fibres optiques selon la revendication 1, caractérisé par le fait que la source de lumière (1) est reliée optiquement, par le biais d'une fibre optique d'alimentation (2) fortement biréfringente à polarisation constante ayant un premier axe optique principal et un deuxième axe optique principal orthogonal au premier, la vitesse de propagation de la lumière dans le premier axe optique principal étant supérieure à celle dans le deuxième axe optique principal, la première fibre optique de référence (4) étant pivotée de 45° par rapport à ses premier et deuxième axes optiques principaux, de manière à ce que les premier et deuxième axes optiques principaux de la première fibre optique de référence (4) forment un angle de 45° avec les premier et deuxième axes optiques principaux de la fibre optique d'alimentation (2).

3. Capteur à transmission à fibres optiques selon la revendication 1 ou 2, caractérisé par le fait que le dispositif de temporisation λ/4 (9) est une boucle λ/4 d'une fibre optique (8) "faiblement biréfringente.

4. Capteur à transmission à fibres optiques selon l'une des revendications précédentes, caractérisé par le fait que le dispositif de temporisation λ/4 (9) est relié optiquement à la deuxième fibre optique de référence (6).

5. Capteur à transmission à fibres optiques selon l'une des revendications précédentes, caractérisé par le fait que le dispositif de temporisation λ/4 (9) et le capteur optique (10) se composent d'une fibre optique unique faiblement biréfringente.
